# EUROPEAN PATENT SPECIFICATION

(11) **EP 3 343 239 B1**
(45) Date of publication and mention of the grant of the patent: **01.05.2024**
(21) Application number: 17210755.9
(22) Date of filing: 27.12.2017
(51) Int. Cl.: G01R 31/50, G01R 19/00

(54) **DIFFERENTIAL CURRENT MONITORING OF MULTIPLE CIRCUITS**
DIFFERENZSTROMÜBERWACHUNG MEHRERER SCHALTKREISE
SURVEILLANCE DE COURANT DIFFÉRENTIEL DE CIRCUITS MULTIPLES

(30) Priority: 28.12.2016 US 201615392766
(43) Date of publication of application: 04.07.2018
(73) Proprietor: Hamilton Sundstrand Corporation, Charlotte, NC 28217-4578 (US)
(72) Inventor: DICKEY, John A., Caledonia, IL 61011 (US)
(74) Representative: Dehns

(56) References cited:
- EP-A1- 2 710 700
- EP-A2- 1 618 442
- EP-B1- 1 618 442
- EP-B1- 2 710 700
- RU-C1- 2 015 595
- US-A- 4 833 459
- US-A1- 2011 254 561
- US-A1- 2013 004 871
- US-A1- 2015 162 157

## Description

### BACKGROUND OF THE INVENTION

### 1. Field of the Invention

The present disclosure relates to current protection, and more particularly to differential current monitoring for current protection.

### 2. Description of Related Art

When distributing power from a bus it is desirable to know when the power into the bus does not equal the sum of the power out of the bus through all the loads. This condition would indicate that there is current loss from the bus to an unwanted location such as ground, i.e., ground fault condition. To implement this check, the sum of all the loads has to be arithmetically subtracted from the source current. This has conventionally required measuring all the currents and then doing the arithmetic to calculate the sums and difference, which is hardware intensive.

Conventional differential current protection can be done by analog current summing or by complex digital arithmetic and high speed communications links. The digital method is often preferred due to the accuracy it provides, however it requires complex field programmable gate arrays (FPGAs) to generate the digital data and perform the sum and difference calculations fast enough to protect against a damaging fault condition.

Differential current monitoring techniques are disclosed in US 4,833,459 and US 2013/004871.

The conventional techniques have been considered satisfactory for their intended purpose. However, there is an ever present need for improved differential current monitoring. This disclosure provides a solution for this problem.

### SUMMARY OF THE INVENTION

A system for differential current monitoring is provided as defined by claim 1.

A method of differential current monitoring is provided as defined by claim 3.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic view of an exemplary embodiment of a system constructed in accordance with the present disclosure, showing the daisy chain arrangement of nodes monitoring current from a bus to respective loads; and
Fig. 2 is a timing diagram of the system of Fig. 1, showing the pulse train for an exemplary embodiment with four nodes.

### DETAILED DESCRIPTION OF THE PREFERRED EMBODIMENTS

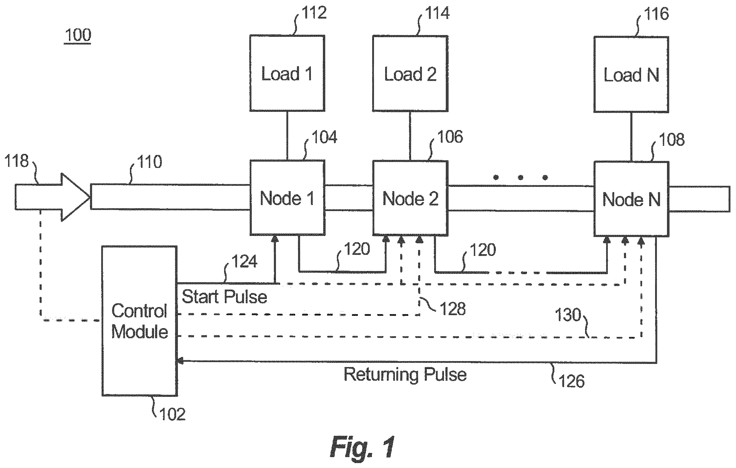

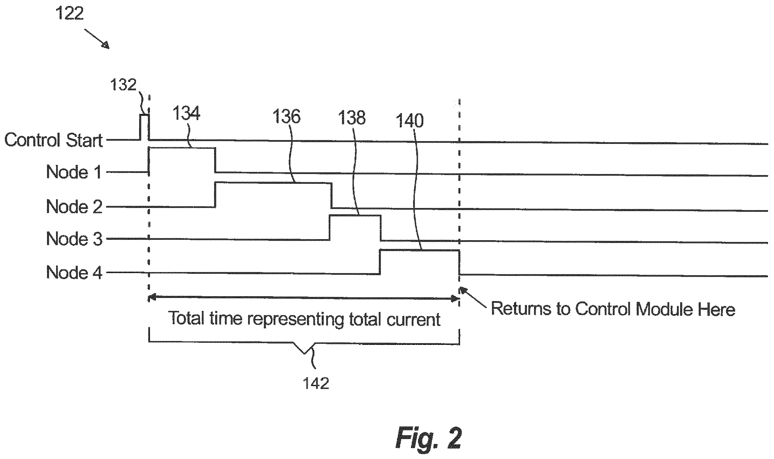

Reference will now be made to the drawings wherein like reference numerals identify similar structural features or aspects of the subject disclosure. For purposes of explanation and illustration, and not limitation, a partial view of an exemplary embodiment of a system in accordance with the disclosure is shown in Fig. 1 and is designated generally by reference character 100. Other embodiments of systems in accordance with the disclosure, or aspects thereof, are provided in Fig. 2, as will be described. The systems and methods described herein can be used for differential current monitoring, for example in high power and/or solid state systems.

System 100 for differential current monitoring includes a control module 102 and a plurality of nodes 104, 106, and 108 operatively connected to the control module 102. Each node 104, 106, and 108 is configured to monitor current from a bus 110 to a respective load 112, 114, and 116. Those skilled in the art will readily appreciate that while shown and described in the exemplary context of having three nodes 104, 106, and 108, the ellipsis in Fig. 1 indicate any suitable number of nodes and respective loads can be included without departing from the scope of this disclosure.

The control module 102 and nodes 104, 106, and 108 are configured to monitor current at each of the nodes 104, 106, and 108 and issue a pulse for each node 104, 106, and 108 (the control module 102 need only directly monitor the current at input 118 of bus 110 and need have no direct bearing on the measurement of current at the nodes 104, 106, and 108). The pulse from each node has a pulse duration that is proportional to current measured or monitored at the node 104, 106, and 108. Control module 102 can sum all of the pulses, e.g. pulse durations, for the nodes 104, 106, and 108 to determine the total current drawn from the bus 110 at the nodes 104, 106, and 1 08. The concatenation of the pulses is what performs the sum. The control module can simply measure the resulting pulse duration from end to end and compares to the current 118. In other words the summation can be the inherent result of the daisy chain of the pulses as further explained below.

Control module 102 is connected to the input 118 of bus 110 so control module 102 can compare the total current drawn from the bus 110 at the nodes 104, 106, and 108 to the current input to the bus 110. If the total current drawn from the bus 110 is not within a predetermined range of the current input to the bus 110, control module 102 can signal a fault condition, such as a ground mode fault.

The nodes 104, 106, and 108 are arranged in a daisy chain 120. Issuing a pulse for each node 104, 106, and 108 can include sequentially issuing a pulse from one node to another along the daisy chain 120 to create a pulse train 122 shown in Fig. 2 and described below, wherein each node 104, 106, and 108 in the daisy chain 120 adds its pulse duration cumulatively to the total time to the end of the pulse train 122. Summing all of the pulses can include measuring duration of round trip time from the first pulse out of the control module 102 until the end of the very last pulse back to the control module 102 from node 108. The duration of round trip time is proportional to the sum of all the current through the nodes 104, 106, and 108.

The control module 102 is directly connected to a first one of the nodes 104 at line 124. Issuing a pulse for each node 104, 106, and 108 can include issuing an initial pulse from control module 102 to the first one of the nodes 104 to initiate transmission of the pulse train 122 along the daisy chain 120. The control module 102 is directly connected to a final one of the nodes 108 at line 126, wherein issuing a pulse for each node 104, 106, and 108 includes transmitting the pulse train 122 back from the final one of the nodes 108 in the daisy chain 120 to the control module 102.

The control module 102 can optionally be directly connected to each of the nodes 104, 106, and 108, e.g., using the dashed extensions of line lines 124 in Fig. 1, or using dedicated lines 128 and 130. In this arrangement, the control module 102 and nodes 104, 106, and 108 can be configured to simultaneously issue a start pulse from the control module 102 to each of the nodes 104, 106, and 108 so that all nodes 104, 106, and 108 sample their respective currents at the same time. The nodes 106 and 108 delay issuing their pulses until the node 104 transmits is pulse to node 106, which transmits its pulse and so on along the daisy chain 120 as described above until the pulse train 122 is returned to control module 102. This arrangement with simultaneous current sampling from all nodes 104, 106, and 108 can be used to reduce errors arising from changes in load while sampling. Both methods, e.g., sending a start pulse to each node simultaneously versus sending a start pulse from each node to the next, can be used and the resulting total sum of current drawn from bus 110 can be compared across the two methods as in internal test for fault modes, e.g., wherein a fault is detected if the difference in pulse train duration across these two methods fails to fall within a predetermined limit.

The method can include monitoring for a timeout condition in the control module 102 in response to failure to receive the pulse train 122 from the last one of the nodes 108 in the daisy chain 120, and reporting a fault in response to the timeout condition. Each of the nodes 104, 106, and 108 can use a common time/current scale factor for issuing the respective pulse, regardless of the number of nodes. The number of nodes can be adjusted, e.g., if loads are added or removed from bus 110.

Fig. 2 shows a start pulse 132, which is issued along line 124 to node 104. Node 104 issues its pulse 134 to node 106 along daisy chain 120. The length or duration of pulse 134 along the horizontal axis in Fig. 2 is proportional to the current monitored at node 104. Node 106 likewise issues its pulse to the next node (in Fig. 2 an exemplary four nodes are used), which issues its pulse 138 to final node 108, which issues its pulse 140 back to control module 102. The total time 142 measured at control module 102 from the end of the start pulse 132 to the end of the pulse train 122, in other words, the end of pulse 140 from the final node 108, is proportional to the sum of the current drawn from bus 110. Those skilled in the art will readily appreciate, having the benefit of this disclosure, that while shown and described in the exemplary context of current monitoring, any suitable metric can be monitored without departing from the scope of this disclosure.

As will be appreciated by one skilled in the art, aspects of the present embodiments may be embodied as a system, method or computer program product. Accordingly, aspects of the present embodiments may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber cable, RF, etc., or any suitable combination of the foregoing.

Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described above with reference to flowchart illustrations and/or block diagrams of methods, apparatus (systems) and computer program products according to embodiments of the embodiments. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks.

Embodiments described herein provide a hybrid digital/analog system and method for differential monitoring of multiple circuits. The methods and systems of the present disclosure, as described above and shown in the drawings, provide for differential current monitoring with superior properties including better noise immunity and accuracy than conventional analog systems and reduced hardware relative to conventional digital techniques. Potential benefits of embodiments disclosed herein include the ability to obtain digital accuracy without the need for field programmable gate arrays (FPGAs) and digital signal processing arithmetic functions, and making use of simple pulse width modulation (PWM) logic that is built into embedded controllers for generating time/current pulses and using a simple timer/counter or simple subtraction to determine if input and output currents are equal. While the apparatus and methods of the subject disclosure have been shown and described with reference to preferred embodiments, those skilled in the art will readily appreciate that changes and/or modifications may be made thereto without departing from the scope of the invention as defined by the claims.

## Claims

1. A system comprising:
a control module (102); and
a plurality of nodes (104, 106, 108) operatively connected to the control module, wherein each of the nodes is configured to:
monitor itself for a metric;
receive a pulse from a sequentially previous node in the plurality of nodes, except in the case of a first one of the nodes which does not have a sequentially previous one of the nodes; and
**characterized in that** each of the nodes is further configured to issue a pulse having a duration equal to a sum of a duration of the pulse received from the sequentially previous node, if there is a sequentially previous node, plus a component that is proportional to the metric monitored at the node; and
wherein a sequentially final one of the nodes issues a pulse that is a concatenation of the pulses of all of the nodes by virtue of having a pulse length that is equal to the duration of the components proportional to the metric monitored of all the nodes, wherein the control module is configured to simultaneously issue a start pulse from the control module to each of the nodes so that all nodes sample their respective currents at the same time.

2. The system as recited in claim 1, wherein the control module and nodes are configured to:
compare total current drawn from a bus at the nodes to current input to the bus; and
signal a fault condition if the total current drawn from the bus is not within a predetermined range of the current input to the bus.

3. A method of monitoring comprising:
monitoring a metric at each of a plurality of nodes;
issuing a pulse for each node, wherein the pulse has a component with a duration that is proportional to the metric monitored at the node; **characterized by** further comprising:
issuing a pulse from one of the nodes having at least one sequentially previous node, said pulse having a duration equal to a sum of a duration of the pulse received from said sequentially previous node plus a component that is proportional to the metric monitored at said one of the nodes;
further comprising simultaneously issuing a start pulse through a respective direct connection to each of the nodes so that all nodes sample their respective currents at the same time.

4. The method as recited in claim 3, further comprising:
comparing total current drawn from a bus at the nodes to current input to the bus; and
signaling a fault condition if the total current drawn from the bus is not within a predetermined range of the current input to the bus.

5. The method as recited in claim 3, wherein the nodes are arranged in a daisy chain and wherein issuing a pulse for each node includes sequentially issuing a pulse from one node to another along the daisy chain to create a pulse train, wherein each node in the daisy chain adds its pulse duration cumulatively to the total time to the end of the pulse train.

6. The method as recited in claim 5, wherein issuing a pulse for each node includes issuing an initial pulse from a control module to a first one of the nodes to initiate transmission of the pulse train along the daisy chain, or wherein issuing a pulse for each node includes transmitting the pulse train back from a final one of the nodes in the daisy chain to a control module.

7. The method as recited in claim 5, wherein issuing a pulse for each node includes issuing an initial pulse from a control module to a first one of the nodes initiate transmission of the pulse train along the daisy chain, wherein issuing a pulse for each node includes transmitting the pulse train back from a final one of the nodes in the daisy chain to the control module, further comprising concatenating all of the pulses including measuring duration of round trip time from the first pulse out of the control module until the end of the very last pulse back to the control module, wherein the duration of round trip time is proportional to the sum of all the current through the nodes.

8. The method as recited in claim 5, further comprising monitoring for a timeout condition in the control module in response to failure to receive the pulse train from the last one of the nodes in the daisy chain; and reporting a fault in response to the timeout condition.

9. The method as recited in any of claims 3 to 8, wherein each of the nodes uses a common time/current scale factor for issuing the respective pulse.

10. The method as recited in any of claims 3 to 9, further comprising adjusting the number of nodes.

## Patentansprüche

1. System, umfassend:
ein Steuermodul (102); und
eine Vielzahl von Knoten (104, 106, 108), die betrieblich mit dem Steuermodul verbunden ist, wobei jeder der Knoten zu Folgendem konfiguriert ist:
sich selbst Überwachen auf eine Metrik;
Empfangen eines Impulses von einem sequentiell vorherigen Knoten in der Vielzahl von Knoten, außer in dem Fall eines ersten der Knoten, der keinen sequentiell vorherigen der Knoten aufweist; und
**dadurch gekennzeichnet, dass** jeder der Knoten ferner dazu konfiguriert ist, einen Impuls auszugeben, der eine Dauer aufweist, die gleich einer Summe aus einer Dauer des Impulses, der von dem sequentiell vorherigen Knoten empfangen wurde, falls es einen sequentiell vorherigen Knoten gibt, plus einer Komponente ist, die proportional zu der Metrik ist, die an dem Knoten überwacht wird; und
wobei ein sequentiell letzter der Knoten einen Impuls ausgibt, der eine Verkettung der Impulse aller Knoten ist, indem er eine Impulslänge aufweist, die gleich der Dauer der Komponenten ist, die proportional zu der überwachten Metrik aller Knoten sind, wobei das Steuermodul dazu konfiguriert ist, gleichzeitig einen Startimpuls von dem Steuermodul an jeden der Knoten auszugeben, sodass alle Knoten ihre jeweiligen Ströme gleichzeitig abtasten.

2. System nach Anspruch 1, wobei das Steuermodul und die Knoten zu Folgendem konfiguriert sind:
Vergleichen eines Gesamtstroms, der von einem Bus an den Knoten entnommen wird, mit einem Strom, der in den Bus eingegeben wird; und
Signalisieren eines Fehlerzustands, falls der von dem Bus entnommene Gesamtstrom nicht innerhalb eines vorbestimmten Bereichs des Stroms liegt, der in den Bus eingegeben wird.

3. Verfahren zum Überwachen, umfassend:
Überwachen einer Metrik an jedem aus einer Vielzahl von Knoten;
Ausgeben eines Impulses für jeden Knoten, wobei der Impuls eine Komponente mit einer Dauer aufweist, die proportional zu der an dem Knoten überwachten Metrik ist; **dadurch gekennzeichnet, dass** es ferner Folgendes umfasst:
Ausgeben eines Impulses von einem der Knoten, der mindestens einen vorherigen Knoten aufweist, wobei der Impuls eine Dauer aufweist, die gleich einer Summe aus einer Dauer des Impulses, der von dem sequentiell vorherigen Knoten empfangen wurde, plus einer Komponente ist, die proportional zu der Metrik ist, die an dem einen der Knoten überwacht wird;
ferner umfassend gleichzeitiges Ausgeben eines Startimpulses durch eine jeweilige direkte Verbindung an jeden der Knoten, sodass alle Knoten ihre jeweiligen Ströme gleichzeitig abtasten.

4. Verfahren nach Anspruch 3, ferner umfassend:
Vergleichen eines Gesamtstroms, der von einem Bus an den Knoten entnommen wird, mit einem Strom, der in den Bus eingegeben wird; und
Signalisieren eines Fehlerzustands, falls der von dem Bus entnommene Gesamtstrom nicht innerhalb eines vorbestimmten Bereichs des Stroms liegt, der in den Bus eingegeben wird.

5. Verfahren nach Anspruch 3, wobei die Knoten in einer Gänseblümchenkette angeordnet sind und wobei das Ausgeben eines Impulses für jeden Knoten sequentielles Ausgeben eines Impulses von einem Knoten zu einem anderen entlang der Gänseblümchenkette beinhaltet, um eine Impulsfolge zu erschaffen, wobei jeder Knoten in der Gänseblümchenkette seine Impulsdauer kumulativ zu der Gesamtzeit bis zum Ende der Impulsfolge addiert.

6. Verfahren nach Anspruch 5, wobei das Ausgeben eines Impulses für jeden Knoten Ausgeben eines Anfangsimpulses von einem Steuermodul an einen ersten der Knoten beinhaltet, um eine Übertragung der Impulsfolge entlang der Gänseblümchenkette einzuleiten, oder wobei das Ausgeben eines Impulses für jeden Knoten ein Zurückübertragen der Impulsfolge von einem letzten der Knoten in der Gänseblümchenkette an ein Steuermodul beinhaltet.

7. Verfahren nach Anspruch 5, wobei das Ausgeben eines Impulses für jeden Knoten Ausgeben eines Anfangsimpulses von einem Steuermodul an einen ersten der Knoten beinhaltet, der eine Übertragung der Impulsfolge entlang der Gänseblümchenkette einleitet, wobei das Ausgeben eines Impulses für jeden Knoten Zurückübertragen der Impulsfolge von einem letzten der Knoten in der Gänseblümchenkette an das Steuermodul beinhaltet, ferner umfassend ein Verketten aller Impulse, was Messen einer Dauer einer Umlaufzeit von dem ersten Impuls aus dem Steuermodul bis zu dem Ende des allerletzten Impulses zurück an das Steuermodul beinhaltet, wobei die Dauer der Umlaufzeit proportional zu der Summe aller Ströme durch die Knoten ist.

8. Verfahren nach Anspruch 5, ferner umfassend Überwachen auf eine Zeitüberschreitungsbedingung in dem Steuermodul als Reaktion auf ein Scheitern, die Impulsfolge von dem letzten der Knoten in der Gänseblümchenkette zu empfangen; und Melden eines Fehlers als Reaktion auf die Zeitüberschreitungsbedingung.

9. Verfahren nach einem der Ansprüche 3 bis 8, wobei jeder der Knoten einen gemeinsamen Zeit-/Stromskalenfaktor zum Ausgeben des jeweiligen Impulses verwendet.

10. Verfahren nach einem der Ansprüche 3 bis 9, ferner umfassend Anpassen der Anzahl von Knoten.

## Revendications

1. Système comprenant :
un module de commande (102) ; et
une pluralité de noeuds (104, 106, 108) connectés fonctionnellement au module de commande, dans lequel chacun des noeuds est configuré pour :
se surveiller pour une mesure ;
recevoir une impulsion provenant d'un noeud séquentiellement précédent dans la pluralité de noeuds, sauf dans le cas d'un premier noeud parmi les noeuds qui n'a pas de noeud séquentiellement précédent parmi les noeuds ; et
**caractérisé en ce que** chacun des noeuds est en outre configuré pour émettre une impulsion ayant une durée égale à la somme d'une durée de l'impulsion reçue en provenance du noeud séquentiellement précédent, s'il existe un noeud séquentiellement précédent, plus une composante qui est proportionnelle à la mesure surveillée au niveau du noeud ; et
dans lequel un noeud séquentiellement final parmi les noeuds émet une impulsion qui est une concaténation des impulsions de tous les noeuds en raison d'une longueur d'impulsion qui est égale à la durée des composantes proportionnelles à la mesure surveillée de tous les noeuds, dans lequel le module de commande est configuré pour émettre simultanément une impulsion de démarrage du module de commande vers chacun des noeuds de sorte que tous les noeuds échantillonnent leurs courants respectifs en même temps.

2. Système selon la revendication 1, dans lequel le module de commande et les noeuds sont configurés pour :
comparer un courant total tiré d'un bus au niveau des noeuds à un courant en entrée du bus ; et
signaler une condition de défaut si le courant total tiré du bus ne se situe pas dans une plage prédéterminée du courant en entrée du bus.

3. Procédé de surveillance, comprenant :
la surveillance d'une mesure au niveau de chacun d'une pluralité de noeuds ;
l'émission d'une impulsion pour chaque noeud, dans lequel l'impulsion a une composante ayant une durée qui est proportionnelle à la mesure surveillée au niveau du noeud ;
**caractérisé en ce qu'**il comprend en outre :
l'émission d'une impulsion à partir de l'un des noeuds ayant au moins un noeud séquentiellement précédent, ladite impulsion ayant une durée égale à la somme d'une durée de l'impulsion reçue en provenance dudit noeud séquentiellement précédent plus une composante qui est proportionnelle à la mesure surveillée au niveau dudit noeud parmi les noeuds ;
comprenant en outre l'émission simultanée d'une impulsion de démarrage, via une connexion directe respective, vers chacun des noeuds de sorte que tous les noeuds échantillonnent leurs courants respectifs en même temps.

4. Procédé selon la revendication 3, comprenant en outre :
la comparaison d'un courant total tiré d'un bus au niveau des noeuds à un courant en entrée du bus ; et
le signalement d'une condition de défaut si le courant total tiré du bus ne se situe pas dans une plage prédéterminée du courant en entrée du bus.

5. Procédé selon la revendication 3, dans lequel les noeuds sont agencés en chaîne et dans lequel l'émission d'une impulsion pour chaque noeud comporte l'émission séquentielle d'une impulsion d'un noeud vers un autre noeud le long de la chaîne pour créer un train d'impulsions, dans lequel chaque noeud de la chaîne ajoute sa durée d'impulsion de manière cumulative au temps total jusqu'à la fin du train d'impulsions.

6. Procédé selon la revendication 5, dans lequel l'émission d'une impulsion pour chaque noeud comporte l'émission d'une impulsion initiale d'un module de commande vers un premier noeud parmi les noeuds pour lancer la transmission du train d'impulsions le long de la chaîne, ou dans lequel l'émission d'une impulsion pour chaque noeud comporte la transmission du train d'impulsions d'un dernier noeud parmi les noeuds de la chaîne vers un module de commande.

7. Procédé selon la revendication 5, dans lequel l'émission d'une impulsion pour chaque noeud comporte l'émission d'une impulsion initiale d'un module de commande à un premier noeud parmi les noeuds pour lancer la transmission du train d'impulsions le long de la chaîne, dans lequel l'émission d'une impulsion pour chaque noeud comporte la transmission du train d'impulsions d'un noeud final parmi les noeuds de la chaîne vers le module de commande, comprenant en outre la concaténation de toutes les impulsions, y compris la mesure de la durée de l'aller-retour de la première impulsion sortant du module de commande jusqu'à la fin de la toute dernière impulsion de retour vers le module de commande, dans lequel la durée de l'aller-retour est proportionnelle à la somme de tout le courant traversant les noeuds.

8. Procédé selon la revendication 5, comprenant en outre la surveillance d'une condition d'expiration de délai dans le module de commande en réponse à un échec de réception du train d'impulsions en provenance du dernier noeud parmi les noeuds de la chaîne ; et le signalement d'un défaut en réponse à la condition d'expiration de délai.

9. Procédé selon l'une quelconque des revendications 3 à 8, dans lequel chacun des noeuds utilise un facteur d'échelle temps/courant commun pour émettre l'impulsion respective.

10. Procédé selon l'une quelconque des revendications 3 à 9, comprenant en outre l'ajustement du nombre de noeuds.
